# EUROPEAN PATENT APPLICATION

(11) **EP 1 931 037 A1**
(43) Date of publication of application: **11.06.2008**
(21) Application number: 06125608.7
(22) Date of filing: 07.12.2006
(51) Int. Cl.: H03M 13/45

(54) **Method and apparatus for processing data from a transmission or storage channel**

(71) Applicant: Deutsche Thomson OHG, 30625 Hannover (DE)
(72) Inventor: Schmitt, Dirk, 78176 Blumberg (DE); Feng, Qilong, 78050 Villingen-Schwenningen (DE); Müller, Stefan, 78048 VS-Villingen (DE)
(74) Representative: Thies, Stephan

(57) **Abstract**

Described is a method and apparatus for read processing data from a channel. In order to correct the most prominent single bit shift errors, competitor words are provided and evaluated along with the hard decided decision words, the competitor words being generated by exchanging the symbol which has the smallest reliability. Four variants are described, how the parallel streams of decision bytes and competitor bytes that are obtained after channel decoding, together with a reliability measure, are exploited in a subsequent error correction decoding stage.

## Description

### Field of the invention

The present invention relates to the field of read processing of digital data, in particular to the field of soft decoding in magnetic, magneto-optical or optical storage readout systems.

### Background of the invention

In a transmission or storage write path for digital data, several steps are performed in series, corresponding inverse steps have to be performed in the associated reception or storage read path. In the write path, data are source coded, error correction coded, and channel coded, all in the digital domain, and then they are modulated into an analog waveform that is suitable for the specific channel. Correspondingly, on the reception or storage read side, the analog channel output waveform, known to be deteriorated by noise, is demodulated, channel decoded, error corrected (ECC decoded), and source decoded. All steps after the demodulation can in principle be performed in the digital domain; moreover, if the input signals are binary (two-valued), a straightforward approach for the read processing also uses binary signals. But, it has been realised as advantageous to generate, to preserve, to exploit, and to forward reliability information, also known as likelihood, to accompany the binary information through the entire processing chain or, at least, through several stages thereof. Methods of this approach are called "soft decision" methods, and more specifically, for single ones of the described processing stages, the nature of the respective input signal and the nature of the respective output signal are described by calling a processing stage for example "soft-input soft-output" or "SISO". Correspondingly, binary data without accompanying reliability information are often called "hard" or "hard-decided" etc. to differentiate them against their "soft" counterparts.

The aspects of source coding and decoding are not considered in this invention any further.

The simplest form of soft-decision decoding uses hard decision demodulation, i.e. a demodulation into binary symbols, together with error flagging, i.e. indicating for each binary symbol, whether or not it is an error, also called erasure. With other words, instead of a one bit binary symbol, we now process a two bit soft symbol. Among these two bits, the flag, if set, marks those symbols whose value is in doubt. Compared to full soft decision decoding, this has three main disadvantages: First, the amount of possible selection is small. Second, subsequent error correction can only use a limited number of erasure flags and possible SISO ECC decoders are not supported. Third, subsequent blocks still receive hard-decided symbols, they are prevented from using any soft output information of preceding blocks.

A SISO channel decoder for the so-called "17pp" run-length limited (RLL) code has been described in Jpn. J. Appl. Phys. Vol.43 (2004) pp . 4882-4883: "Soft-Output Decoding of 17 Parity Preserve/Prohibit Repeated Minimum Transition Runlength (PP) Code". This can be seen to have the disadvantage that the feasability of the approach there is tied to a special RLL code, the so-called "17pp code" being used. Most other RLL codes have no trellis structure, so that the approach can not be generalised onto them.

### Invention

The present invention proposes a SISO read processing for transmission or storage channels. In it, a SISO demodulator provides a sequence of incoming symbols together with reliability information to an extended channel decoder having a BDD block and a channel decoder block. From there, data are forwarded to an ECC decoder block, which is also specific for this invention. After the SISO demodulator, the incoming symbols are grouped into vectors of as many symbols as there are bits in the channel code words.

The BDD block first produces, from each of the incoming received vectors, which are not necessarily channel codewords, a so-called decision word and a competitor word. The decision word is the vector resulting from individually hard-deciding the symbols of the received vector, the competitor word is derived from the decision word by flipping (inverting) that symbol (bit) which has the smallest reliability. With other words, the competitor word is the word which is closest to the decision word. The BDD block provides this closeness information as a reliability information between the decision and competitor words. The decision words and competitor words are subsequently both being channel decoded into decision bytes and competitor bytes, respectively.

Rather than forcing a hard decision that is somewhat likely to be incorrect, the soft-decision read processing according to the invention provides an alternative for each processed codeword, and passes the quality of the demodulated symbol expressed in probabilities to a subsequent error control decoder, thereby providing an expanded selection of choices. This enables the subsequent ECC decoder to be realised as a Soft-In-Soft-Out (SISO) decoder, as well, so that the latter can employ the powerful mechanism of turbo decoding. With other words, the invention presents a method, which enables to use and share reliability information among the channel decoding and error correction processes.

The idea of the invention is to correct the most prominent single bit shift errors by providing and evaluating a competitor, which is generated by exchanging the symbol within the codeword which has the smallest reliability.

The invention builds on the assumption that the most probable error in maximum likelihood decoding is the 1T bit shift error, and that in most cases, only one of these bit shift errors appears per codeword. Another assumption is that the bit shift errors are distributed randomly within the symbol stream, so burst errors are not covered with this method.

### Drawings

Exemplary embodiments of the invention are illustrated in the drawings and are explained in more detail in the following description.

In the figures:

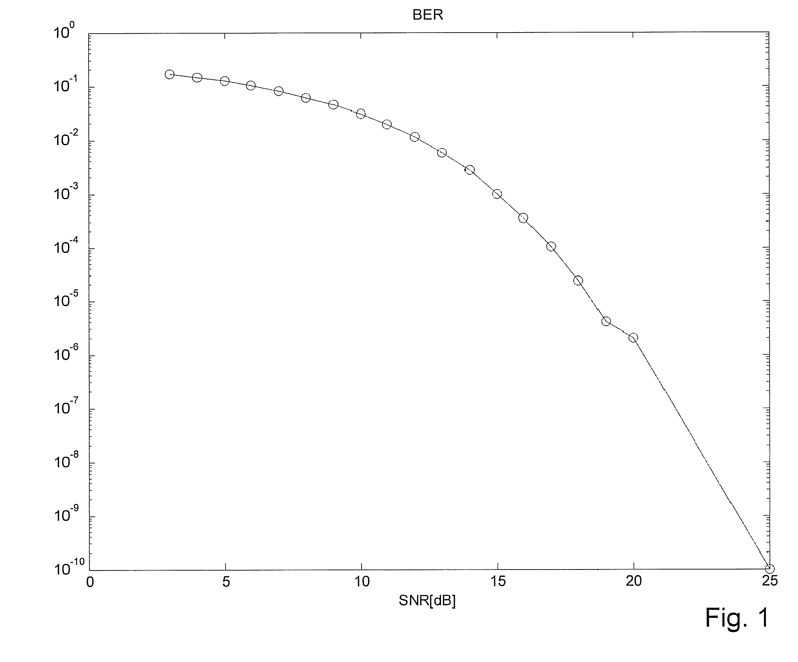

- Fig. 1: shows bit error rate BER of a DVD channel code;
- Fig. 2: shows typical error distribution in optical transmission channel;
- Fig. 3: shows a top-level block diagram of an apparatus according to the invention;
- Fig. 4: shows absolute numbers of correctable and uncorrectable bytes;
- Fig. 5: illustrates the determining of the competitor word;
- Fig. 6: illustrates the quality of the generated reliability signal;
- Fig. 7: shows a first reliability histogram at 15 dB SNR, the overall mean reliability is 0.5369;
- Fig. 8: shows a second reliability histogram of only the correctable bytes at 15 dB SNR, the mean reliability is 0.0215;
- Fig. 9: shows a third reliability histogram at 10 dB SNR, the overall mean reliability is 0.3016;
- Fig. 10: shows a fourth reliability histogram of only the correctable bytes at 10 dB SNR, the mean reliability is 0.0719;
- Fig. 11: shows the Byte error position vs. the reliability information;
- Fig. 12: illustrates the Exchange algorithm before the error correction block;
- Fig. 13: shows byte error rates for different algorithms, for the case of EFM+ demodulation with a short BCH(7,6) error correction code; and
- Fig. 14: shows byte error rates for different algorithms, for the case of EFM+ demodulation with a short CRC(16,15) detection code.

### Exemplary embodiments

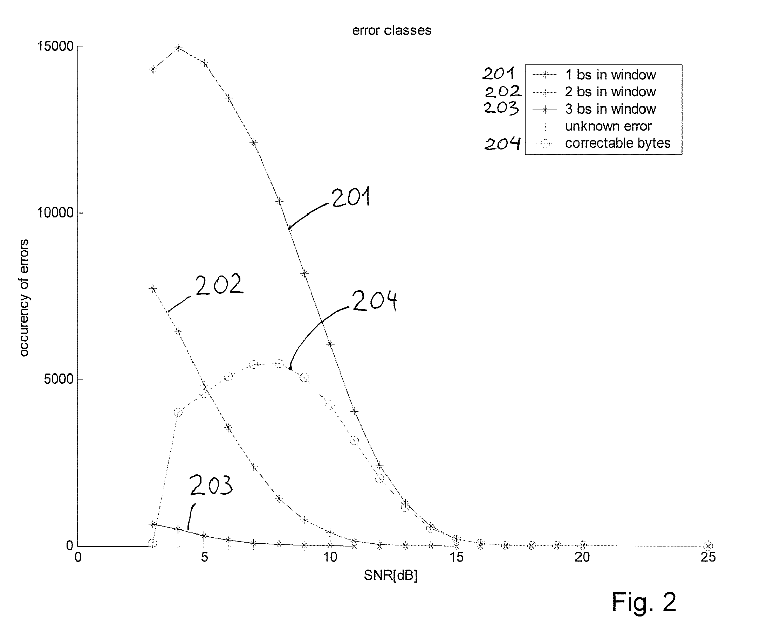

**Figure 2** shows a typical distribution, in absolute number of occurrencies in a simulation data sample, of bit shift and non-bit shift errors of a 16/8 block code, over the signal-to-noise ratio SNR. The window in this measurement is 16 bits, corresponding to 1 codeword in EFM+. Most of the errors in a noisy channel made by trellis-based channel decoding (BCJR, Viterbi, etc.) are 1 bit shift errors. Figure 2 shows that the majority of 1 bit shift errors are single errors in one codeword 201. Double errors in a codeword 202 occur much less frequent, triple errors in a codeword 203 even less so. The absolute number of correctable bytes 204 is also shown. Codeword length is assumed as 16 symbols, here, as it is used for EFM+ channel code.

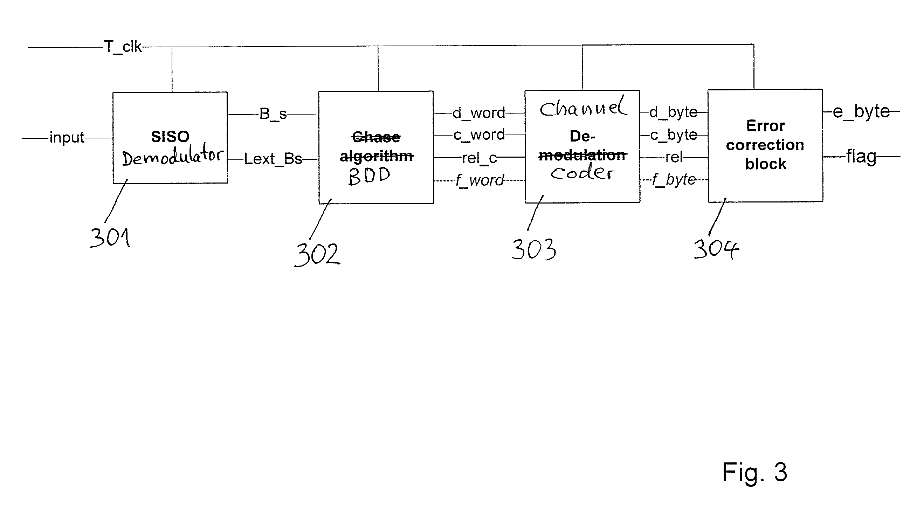

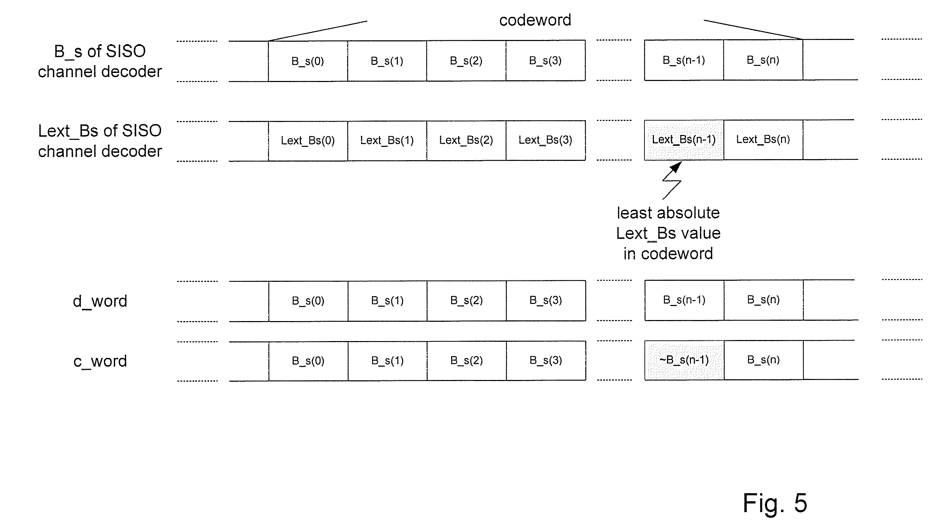

**Figure 3** shows the top-level overview of an apparatus according to the invention. d_word is the decision word, c_word is the competitor word, f_word is the decision word where first bit is flipped, d_byte is the decision byte, c_byte is the competitor byte, f_byte is the channel decoded f_word, and e_byte is the ECC decoded byte. First the incoming stream of samples of the so-called HF signal, input, is fed to the SISO demodulator 301, which generates a symbol stream B_s accompanied by reliability information Lext_Bs for each symbol. The two signals are fed to the BDD block 302 which generates a decision word d_word, a competitor word c_word and the closeness or reliability information rel_c between the two words. The BDD block 302 performs the steps of:
1. Determine the decision word d_word by using the sign of the incoming reliability values Lext_Bs.
2. Determine the competitor word c_word by using the sign of the incoming reliability values Lext_Bs with subsequently flipping the sign of that symbol which has the least absolute reliability value.
3. Calculate the reliability measure rel_c according to rel_c = |R - C|,
where R =(rn, rn-1, ... r0) is the received reliability vector of the decision word, C =(c_cwn, c_cwn-1, ... c_cw0) is the reliability vector of the competitor word, and n is the codeword length. **Fig. 5** illustrates the determining of the competitor word. The reliability rel_c calculated in step 3 is set to 0 if no decision word exists and is set to INF if no competitor word exists. The reliability rel_c calculated in step 3 is used in the subsequent ECC block 304 for byte error location.

The action of the BDD block 302 can be seen as a degenerated minimum form of the known Chase decoding, because it investigates just a single error pattern that assumes a bit error at the least reliable bit position. Alternatively, it can also be seen as a degenerated minimum form of GMD decoding, because it performs algebraic decoding only for the case of a single erasure at the least reliable position. Chase and GMD decoding both are instances of Bounded Distance Decoding (BDD), hence the block's name.

After the action of the BDD block 302, the Channel Decoder block 303 decodes the two streams and sends the decoded decision bytes d_byte and the decoded competitor bytes c_byte to the subsequent Error correction block 304. Together with these, the associated reliability information rel_c from the BDD block 302 is also forwarded as reliability information rel to the subsequent error correction block 304.

The quality of the reliability information rel_c/rel generated by the BDD block 302 is critical for the error correction capability. The reason is that the Error correction block 304, according to the invention uses the reliability information to adaptively replace some of the decision bytes d_byte within an ECC block by the associated competitor bytes c_byte, if the error correction process based on the decision bytes d_byte fails. With other words, the reliability information rel is used by the Error correction block 304 to decide which of the decision bytes d_bytes should be exchanged or replaced by the associated competitor bytes c_bytes. The Error correction block 304 determines the error corrected data stream e_byte by using the decision data bytes d_byte, the competitor data bytes c_byte and the reliability information rel.

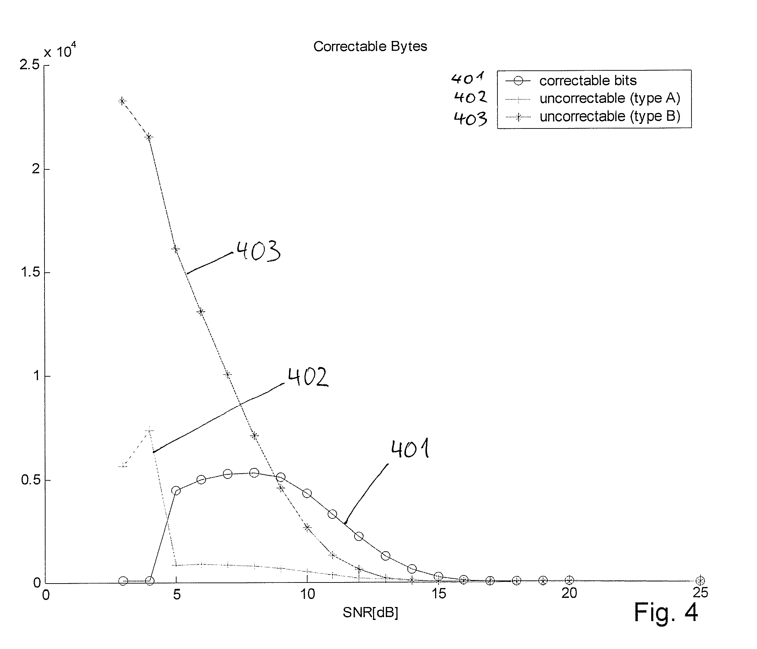

**Figure 4** shows different error classes. Class A 401 describes the number of erroneous decision codewords which were successfully corrected by exchanging the decision codeword with the competitor codeword, with other words, where a one bit shift error caused a wrong but correctable demodulated data word. Class B 402, only for EFM+, describes the number of erroneously decided codewords which were corrected by exchanging also the codewords which generates next state errors, with other words, those where an (EFM+) bit error in bit 15 or bit 3 caused a wrong next state detection.
Class C 403 is the number of erroneous codewords which were not able to be corrected by this algorithm, with other words, those where more than one bit shift error occurred in one codeword, where the smallest reliability does not coincide with the bit error position, or cases of other unknown error.

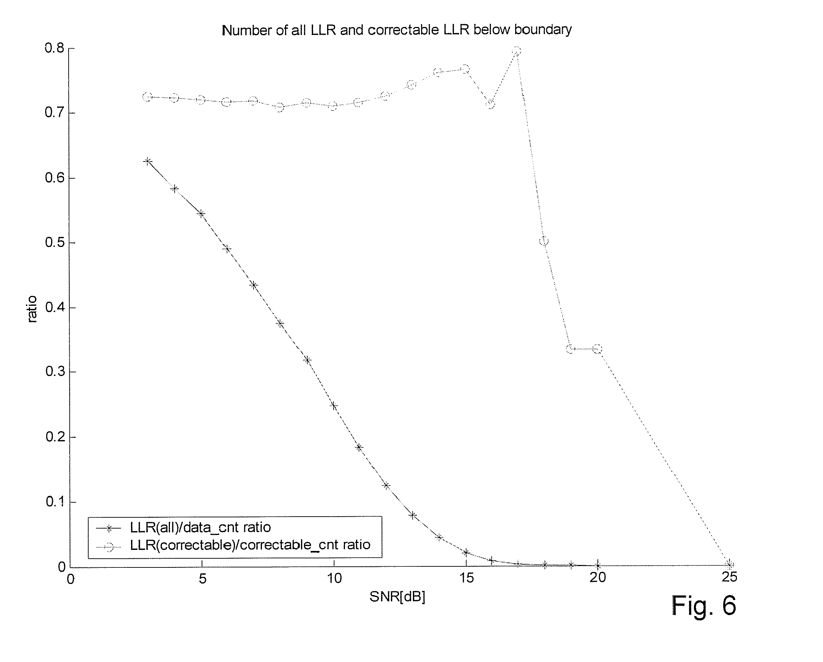

**Figure 6** shows the quality of the reliability information rel. Here the number of those Class A samples is counted where the reliability rel is below the mean borderA of the reliability rel of Class A. Also the number of all those samples is counted, whose reliability rel is below the mean of the Class A reliability rel. The Figure shows that for 75% of the Class A samples, their reliability rel is below the borderA. For the entire set of all samples, the number of samples having reliability rel below borderA decreases monotonically with increasing SNR of the transmitted stream.

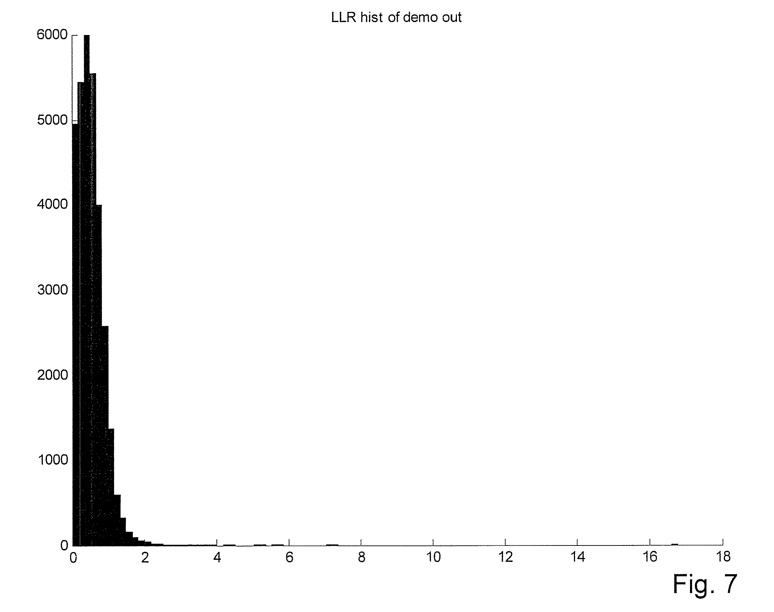

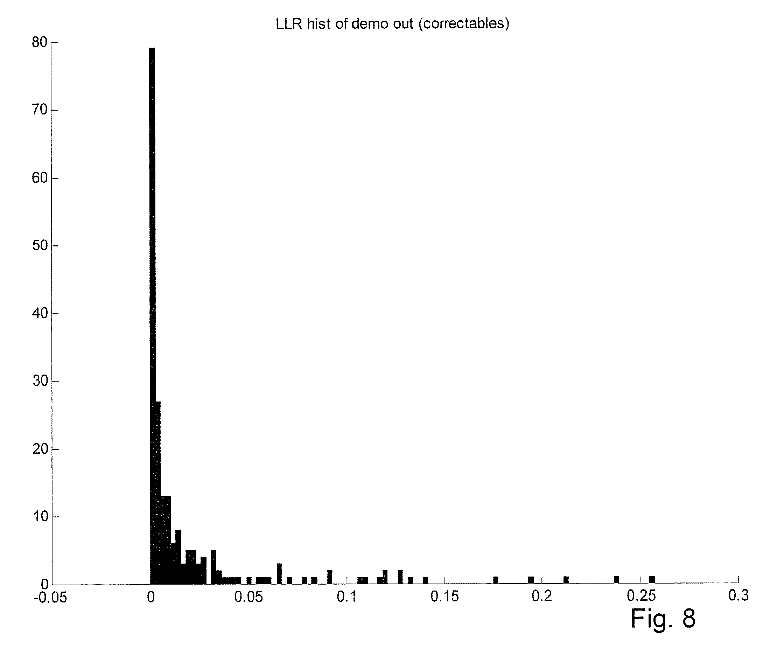

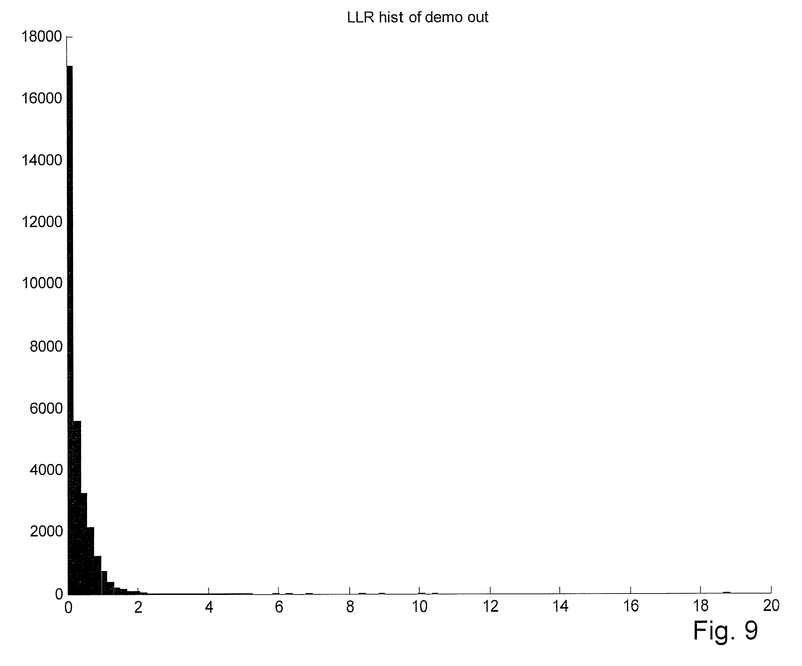

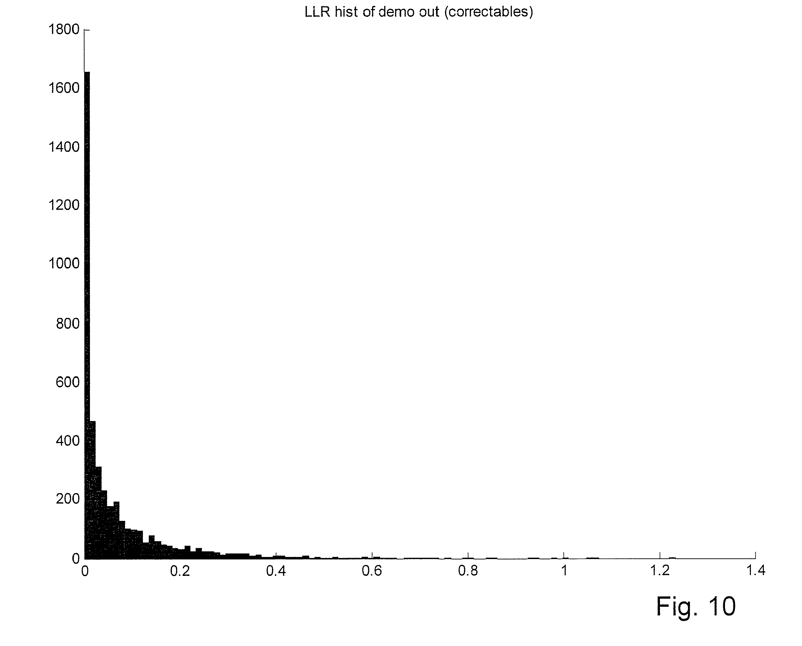

**Figure 7** and **Figure 9** show the distribution of the reliability magnitude rel of the Class A samples for two different SNR values, while **Figure 8** and **Figure 10** show the distribution of the reliability magnitude, i.e. absoulte reliability, rel of all samples for the same two different SNR values.

For quality measurement the mean reliability of Class A errors is calculated. Then the Class A errors number of samples below the mean value are counted and the number of samples with a reliability below the mean value is counted. The ratio is determined by dividing the Class A samples below mean value by the total number of Class A errors. Also the number of samples having a reliability below the mean is divided by the total number of data bytes to get a ratio.

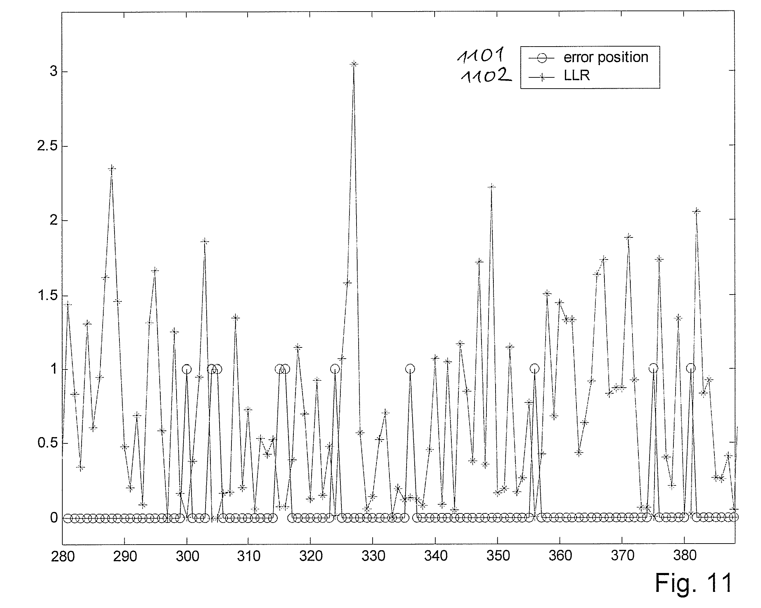

**Figure 11** shows the value of the reliability magnitude rel, LLR, 1102 and the byte error positions 1101 that are present in the test set. It can be seen that the reliability rel, 1102 is small at the error positions 1101.

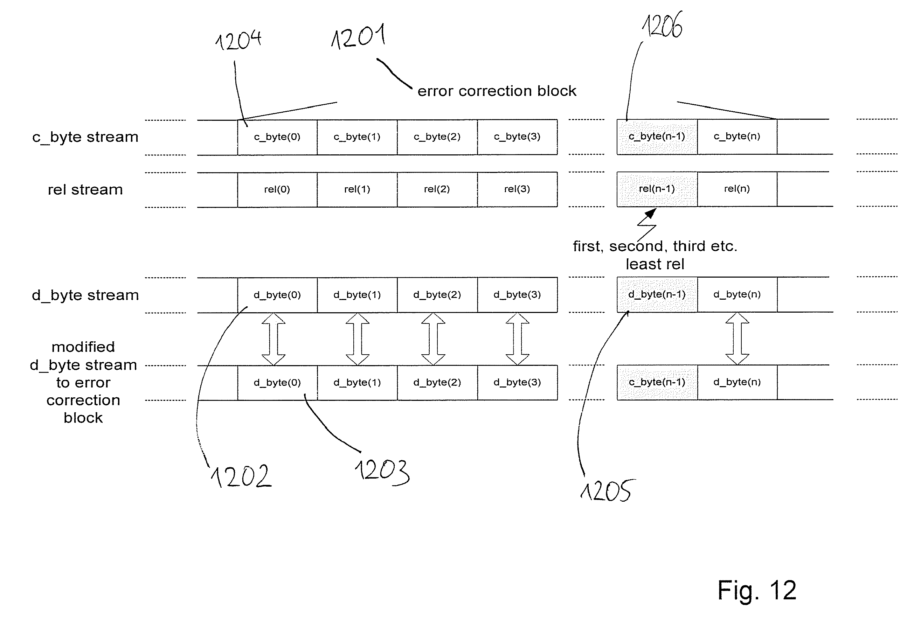

The Error correction block 304 receives from the channel decoder block 303 sequences of decision bytes d_byte, competitor bytes c_byte and the associated reliability information rel. In the following it is assumed that one ECC block 1201 consists of several bytes 1202, 1203, 1204, as shown in **Figure 12**, so that for the ECC decoding 304, sets of bytes are being collected and are being processed together. On these data, one of four algorithms according to this invention is then advantageously used:

### Algorithm 1, a GMD-like algorithm

The Error correction block 304 tries to ECC decode the set of decision bytes within the ECC block 1201. If no error occurs, the decision bytes 1202 pass the Error correction block 304. If an error occurs, then the Error correction block 304 replaces that decision byte d_byte, 1205 with the associated competitor byte c_byte, 1206, which has the smallest reliability rel among all bytes of the ECC block 1201. This is illustrated in **Figure 12****.** There, n designates the number of bytes per ECC block 1201. The ECC decoder 304 then tries again, namely this time to ECC decode the thus modified byte stream, and sends the bytes of the resulting ECC decoded block e_byte to the subsequent unit, not shown. If an error occurs, these ECC block bytes e_byte are marked as erroneous flag.

### Algorithm 2, the GMD-like algorithm iterated

The first iteration of the error correction is like in Algorithm 1. Then, if after the first iteration an ECC decoding error persists, the Error correction block 304 additionally replaces that decision byte d_byte, 1205 with the associated competitor byte c_byte, 1206, which has the smallest but one reliability rel among the bytes of the ECC block 1201, and tries to ECC decode again. Further iterations replacing the least but two, least but three, etc. decision byte d_byte can optionally be performed. In the end, as in Algorithm 1, the bytes of the ECC decoded block e_byte are sent to the subsequent unit; if an ECC decoding error persists after all the iterations, the ECC block bytes are marked as erroneous.

### Algorithm 3, for EFM+

This corresponds to the GMD-like algorithm iterated plus an additional next state correction. The iterations are as in Algorithm 2, but this algorithm additionally allows to correct next state errors which occur in the special case of the EFM+ code if bit3 or bit15 of the preceding codeword is erroneous.

### Algorithm 4, for NRZI

This corresponds to the GMD-like algorithm iterated plus a flip first correction. For NRZI modulated streams, if there is a bit error at the last bit of the codeword, the subsequent codeword is also erroneous, because the NRZI modulation corresponds to a transfer function of "1+D". In Algorithm 4, iterations are as in Algorithm 2, but there is also a demodulated data byte stream f_byte where the first bit of the decision codeword is flipped f_word. So if an error occurs in the last bit of the preceding codeword, the next data byte is also defective. Therefore in all those cases where the exchange algorithm replaces the decision data byte d_byte with the competitor data byte c_byte and the competitor data byte c_byte was generated by flipping the last bit of the competitor codeword c_word, the subsequent data byte is also exchanged with the flip first data byte f_byte.

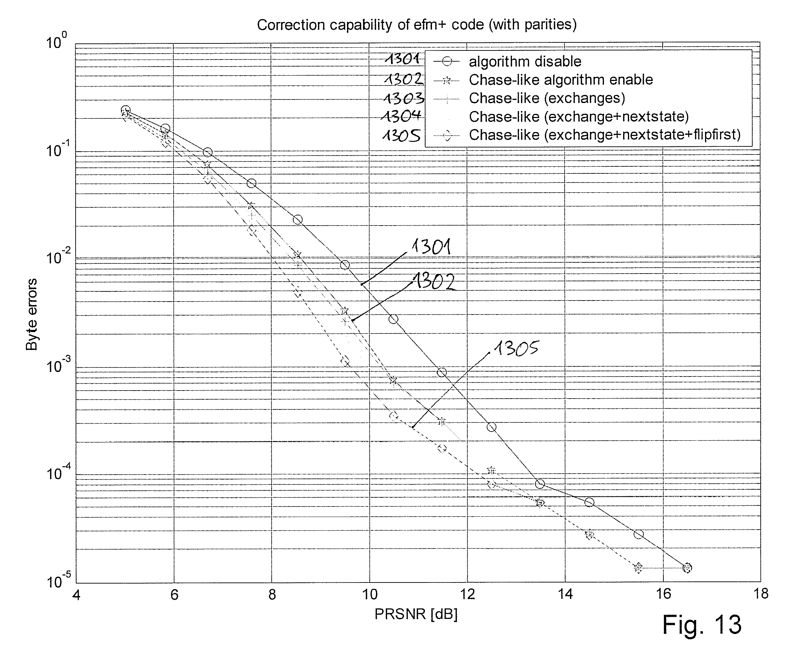

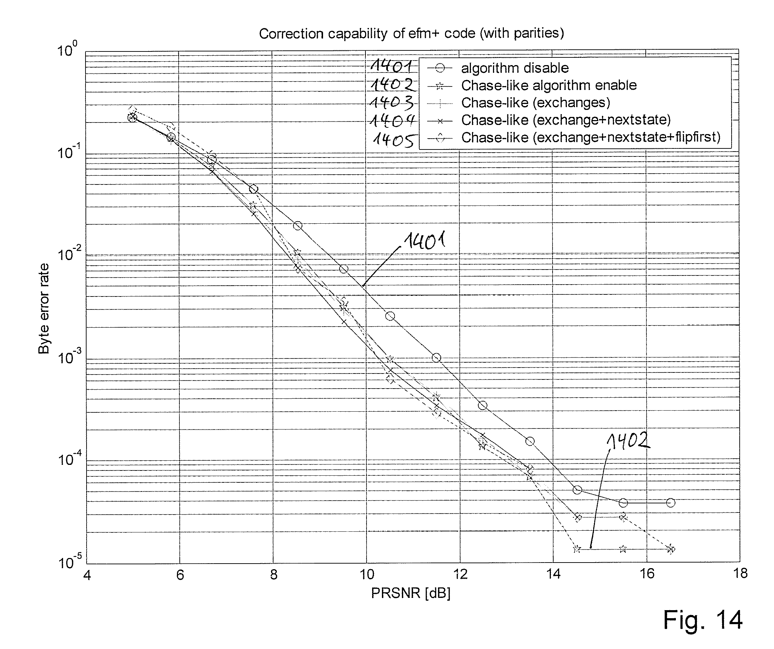

**Figure 13** and **Figure 14** shows the result of the invention with two error control codes. While **Figure 13** shows the result of the invention with a BCH(7,6) code, **Figure 14** shows the result of the invention with a CRC(16,15) code. In **Fig. 13**, percentages of byte errors are shown in curve 1301 with the algorithm disabled, in curve 1302 with a Chase-like algorithm enabled, in curve 1303 with Algorithm 2 as described above, in curve 1304 with Algorithm 3 as described above, and in curve 1305 with Algorithm 4 as described above. In **Fig. 14****,** percentages of byte errors are shown in curve 1401 with the algorithm disabled, in curve 1402 with a Chase-like algorithm enabled, in curve 1403 with Algorithm 2 as described above, in curve 1404 with Algorithm 3 as described above, and in curve 1405 with Algorithm 4 as described above.

The simulation parameters are: 500,000 channel bits, 30480 data bytes, and 335 sync words. Channel decoding uses a MAX-APP decoder with a 1200 channel bits window size. The channel is a PR(1221) channel with additive noise, colored with low pass (fcut=3T).

The advantage of the invention is, that the error correction block is able to correct symbols only by an exchange algorithm and without the whole correction processing. So the error correction corrects more errors than what the correction capability of the error correction code allows. Also the error correction block gets reliability information about demodulated bytes.

The invention can be applied to all type of digital baseband transmission systems which use block codes.

## Claims

1. A method of soft-in soft-out read processing digital data, comprising:
- providing (301) incoming symbols (B_s) with associated reliability informations (Lext_Bs),
- producing a decision word (d_word) by hard deciding incoming symbols (B_s) and grouping them into a vector,
- producing a competitor word (c_word) by exchanging that symbol of the decision word (d_word) which has the smallest reliability information (Lext_Bs),
- channel decoding (303) the decision words (d_word) and competitor words (c_word) into decision bytes (d_byte) and competitor bytes (c_byte), respectively,
- performing error correction decoding (304) using the decision bytes (d_byte) and the competitor bytes (c_byte).

2. The method of claim 1, additionally comprising:
- producing (302) a reliability measure (rel_c, rel) for every pair of decision word (d_word) and competitor word (c_word),
- passing the reliability measures (rel_c, rel) to the error correction decoding step (304) to be used therein.

3. The method of claim 2, where the step of producing (302) a reliability measure (rel_c) comprises calculating the reliability measure as the norm of the difference between the vector of the reliability informations of the decision word (d_word) and the vector of the reliability informations of the competitor word (c_word).

4. The method of claim 2 or 3, wherein the step of performing error correction decoding (304) comprises:
- first ECC decoding the decision bytes grouped (1201) into an ECC block,
- in case an error occurs in the first ECC decoding, modifying the decision bytes (1202) of the ECC block by replacing that decision byte (d_byte) by the associated competitor byte (c_byte), which has the smallest reliability (rel) among all bytes of the ECC block, and last ECC decoding the modified decision bytes (1203),
- passing the bytes of the resulting ECC decoded block (e_byte) to the output of the ECC decoder (304),
- in case an error occurs in the last ECC decoding, marking (flag) these ECC decoded bytes as erroneous.

5. The method of claim 4, comprising, between the step of modifying the decision bytes (1202) and the step of last ECC decoding the modified decision bytes (1203), steps of:
- next ECC decoding the modified decision bytes (1203) of the ECC block,
- in case an error occurs in the next ECC decoding, further modifying the decision bytes (1202) by replacing that decision byte (d_byte) by the associated competitor byte (c_byte), which has the next smallest reliability (rel) among all bytes of the ECC block,
- looping back to the next ECC decoding step.

6. The method of claim 5, wherein if an error occurs in the last bit of a word, in the subsequent decision word, the first bit is flipped, and the resulting flipfirst word is used in subsequent processing instead of the subsequent decision word.

7. An apparatus for soft-in soft-out read processing data from a channel, having a soft-input soft-output demodulator (301), a Bounded Distance Decoder Block (302), a Channel Decoder block (303), and an Error Correction Decoder block (304), **characterised by** being configured to perform a method according to one of the previous claims.
